Europäisches Patentamt

European Patent Office

Office européen des brevets

(19)

(11) Publication number: **0 202 961**
**B1**

(12) # EUROPEAN PATENT SPECIFICATION

(45) Date of publication of patent specification :
30.08.89

(51) Int. Cl.⁴ : **G 03 B 41/00**

(21) Application number : 86400678.8

(22) Date of filing : 27.03.86

(54) **Apparatus for projecting and exposing a photomask pattern onto re-exposing substrates.**

(30) Priority : 27.03.85 JP 62444/85

(43) Date of publication of application :
26.11.86 Bulletin 86/48

(45) Publication of the grant of the patent :
30.08.89 Bulletin 89/35

(84) Designated contracting states :
DE FR GB

(56) References cited :
EP--A-- 0 091 199
DE--A-- 2 843 541
DE--A-- 2 939 204
DE--A-- 3 247 560
SOLID STATE TECHNOLOGY, vol. 26, no. 5, May 1983, pages 87-91, Port Washington, US; D. BERRY et al.: "Application of automatic alignment to MOS processing in projection printing"

(73) Proprietor : FUJITSU LIMITED
1015, Kamikodanaka Nakahara-ku
Kawasaki-shi Kanagawa 211 (JP)

(72) Inventor : Ohta, Kazutoshi
24-9, Fujigaoka 1-chome Midori-ku
Yokohama-shi Kanagawa 227 (JP)

(74) Representative : Descourtieux, Philippe et al
CABINET BEAU de LOMENIE 55 rue d'Amsterdam
F-75008 Paris (FR)

## Description

The present invention relates to an apparatus for projecting and exposing a photomask pattern onto re-exposing substrates. More particularly the present invention relates to an apparatus for transcribing a standard photomask pattern of a master mask onto a plurality of re-exposing substrates, where the re-exposing substrates will become work masks used for patterning semiconductor devices, such as semiconductor chips, or are semiconductor wafers for producing semiconductor devices.

The methods for projecting and exposing a photomask pattern of a master mask to a re-exposing substrate can be. classified into the three following ones : the contact method performed by directly attaching the re-exposing substrate to the master mask, the proximity method performed by bringing the re-exposing substrate proximately close to the master mask, and the projection method performed by projecting the image of the photomask pattern of a master mask onto a re-exposing substrate using an exposing optical system. The contact method or the proximity method has the merit that it can be simply performed ; that is, the contact method can be performed by only directly contacting the re-exposing substrate with the master mask, and the proximity method can be performed by only setting the re-exposing substrate very close to the master mask. However, these two methods have a drawback in that a standard photomask pattern provided on the surface of the master mask is easy to be damaged because the re-exposing substrate directly touches or may easily touch the standard photomask pattern during the projecting and/or exposing process. Accordingly, recently, the projection method has become more widely used because it can be performed without any contact or risk. of contact between the surfaces of the re-exposing substrate and the master mask. Applying the projection method to the patterning process for the work mask production causes the working life of the master mask to increase, and the production cost of the work mask can be reduced.

However, using the projection method may cause the accuracy of the transcription of the photomask pattern to the re-exposing substrate to decrease. During the projection and exposition of the photomask pattern to a plurality of the re-exposing substrates in the production of the work masks, it cannot be avoided that phenomena such as heat expansion, heat contraction, and mechanical vibration occur in the mask aligner. When the phenomena occur in the master mask, the re-exposing substrate, and/or the projecting optical system, the transcribing accuracy decreases, with the result that the photomask pattern transcribed on each work mask cannot be used any more because it is distorted.

Since the re-exposing substrates become the work masks after the development and each work mask is applied to the production of semiconductor devices such as semiconductor chips, the quality of the photomask pattern, called as the work photomask pattern, of each work mask gives great influence to the cost of the semiconductor chips. For example, if the work photomask pattern has a defect and is applied to the production of the semiconductor chips without noticing the defect, all production of the semiconductor chips become a failure. Therefore, each work photomask pattern must have been individually inspected even though the inspection takes a lot of time.

It is therefore an object of the invention to provide an apparatus which make it possible to increase the transcribing accuracy of photomask patterns from the master mask to the work masks when a plurality of work masks are required to be produced.

Another object of the present invention is to decrease the time for inspecting the photomask patterns projected onto the re-exposing substrates keeping the accuracy of the photomask patterns projected on the re-exposing substrates high when the photomask pattern is individually and sequentially exposed onto a plurality of re-exposing substrates.

Still another object of the present invention is to decrease the production cost of work masks.

In order to accomplish these objects, there is provided, according to the invention, a mirror projecting mask aligner comprising a light source unit and a projecting optical unit in which a carriage means is installed for carrying a master mask, a re-exposing substrate and a standard marker substrate, this standard marker substrate being permanently positioned in close proximity to said re-exposing substrate.

In a second embodiment of a mirror projecting mask aligner according to the invention, it comprises a light source unit and a projecting optical unit with an optical imaging mirror system and a carriage means for carrying a master mask, a re-exposing substrate and a standard marker substrate ; this standard marker substrate is permanently positioned in the focal plane of said optical imaging mirror system, and a further optical imaging means is provided for imaging the image of the master mask and position marks of said standard marker substrate onto said re-exposing substrate.

Further features and advantages of the apparatus according to the invention will become more readily apparent from the following description made with reference to the accompanying drawings wherein :

Fig. 1 is a schematic sectional illustration of a projecting and exposing apparatus of the prior art ;

Fig. 2 is a schematic sectional view of a first mask aligner embodying the present invention ;

Fig. 3 is a schematic diagram for illustrating the optical system of the first mask aligner;

Fig. 4 is a schematic sectional view of a second mask aligner embodying the present invention;

Fig. 5 is a schematic diagram for illustrating the optical system of the second mask aligner;

Fig. 6 is a schematic view of first positioning marks and of a standard photomask pattern formed on a master mask used in the first or the second mask aligner;

Fig. 7 is a schematic view of second positioning marks formed on a standard marker substrate used in the first or the second mask aligner; and

Fig. 8 is a schematic view of the images of positional marks and photomask pattern projected onto a re-exposing substrate.

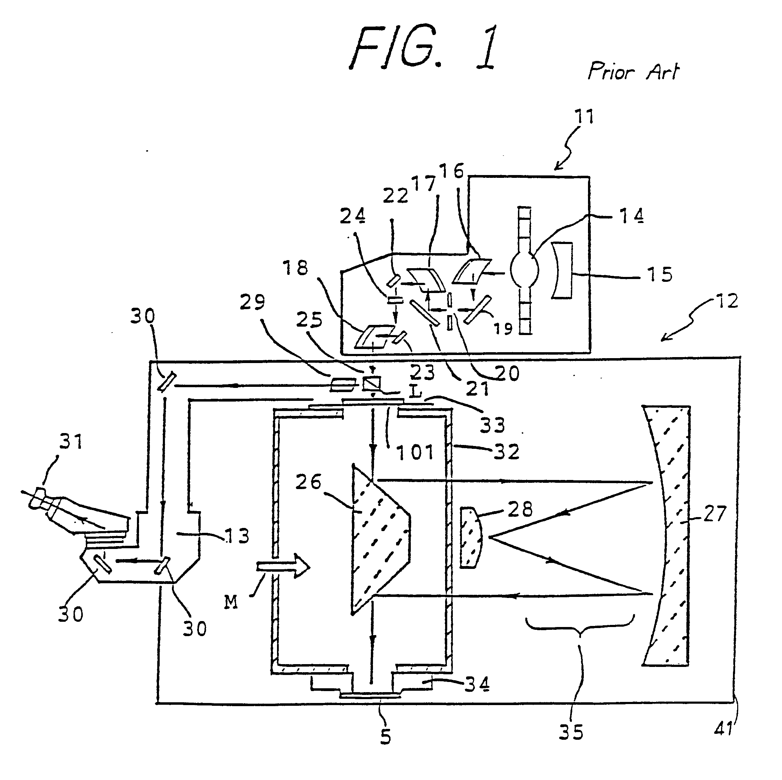

Fig. 1 is a schematic sectional illustration of a projecting and exposing apparatus of the prior art. The apparatus is made by Canon Incorporation and named as « Mirror Projection Mask Aligner MPA 500 FA or 600 FA » which will be abbreviated as « mask aligner » hereinafter.

As shown in Fig. 1, the mask aligner comprises a light source unit 11 and a projecting optical unit 12 in which a carriage 32 is installed. The light source unit 11 is tightly mounted on a framework 41 of the projecting optical unit 12, and carriage 32 is mounted inside of the framework 41 so as to be movable with respect to the framework 41 in a direction M.

In the light source unit 11, the light emitted from a light source 14, which is a xenon-mercury (Xe-Hg) lamp, is gathered by spherical mirrors 15 and 16, reflected by a cold mirror 19 ejecting heat radiation emitted from light source 14, and sent to a slit 20 having a shape of a slender circular arc. The light which has passed through the slit 20 is reflected by aluminum plane mirrors 21, 22 and 23 and spherical mirrors 17 and 18 and is led to the projecting optical unit 12 passing through a filtering shutter 24. The light which has arrived at projecting optical unit 12 passes through a half mirror 25 and forms a light beam L with a transverse section having a similar shape to the shape of slit 20, thus producing an image of slit 20 at the beam entrance of carriage 32. At said beam entrance of carriage 32, there is provided a mask holder 33 on which a master mask 101 is mounted. The light beam L which has passed through a standard photomask pattern of master mask 101 is nearly perpendicularly reflected by one face of a trapezoidal reflector 26, condensed by a condensing mirror system 35 consisting of a concave mirror 27 and a convex mirror 28, again reflected by another face of the trapezoidal reflector 26, and produces an image of the standard photomask pattern at the beam exit of carriage 32. At said beam exit of carriage 32, there is provided a mounting base 34 on which a re-exposing substrate 5 is mounted, so that the image of the standard photomask pattern is projected on said re-exposing substrate. In other words, the positions where the master mask 101 and the re-exposing substrate 5 are mounted constitute conjugate positions of the condensing mirror system 35.

The condensing mirror system 35 and the trapezoidal reflector 26 are fixed to the framework 41, which means that light beam L constantly passes along a fixed route, which is an optical axis of condensing mirror system 35, in the framework 41. By contrast, the carriage 32 is mounted in the framework 41 with the interposition of an air bearing (not shown in Fig. 1) so that carriage 32 can move in direction M carrying master mask 101 and re-exposing substrate 5.

Therefore, when the slender circular arc spotlight image of slit 20 is formed on the surface of master mask 101 and runs across the surface of master mask 101 perpendicularly to direction M, the movement of carriage 32 is such that the slender circular arc spotlight scans over the surface of master mask 101. Accordingly, by the movement of carriage 32 in direction M, the image of the standard photomask pattern of master mask 101 can be projected and exposed onto the re-exposing substrate 5.

The projecting and exposing process is generally performed in two steps using the mask aligner: an alignment step and an exposing step. In the alignment step, the mounted positions of master mask 101 and re-exposing substrate 5 are aligned so that said positions become conjugate positions of condensing mirror system 35, and the surfaces of master mask 101 and re-exposing substrate 5 become perpendicular to the light beam L or the optical axis of condensing mirror system 35, respectively. In the exposing step, the standard photomask pattern of master mask 101 is exposed onto the re-exposing substrate 5. In the production of work masks, the alignment step is usually carried out once, and after the alignment step, the exposing step is applied to the rest of the re-exposing substrates, one by one, in order to save production time.

More precisely, the alignment step is carried out by: (1) previously providing a plurality of first positioning marks on the surface of the master mask 101 around the standard photomask pattern; (2) mounting the master mask 101 on the mask holder 33; (3) newly preparing a standard marker substrate on which a plurality of second positioning marks are provided with the same arrangement pitch as the arrangement pitch of the first positioning marks; (4) mounting the standard marker substrate, which is not shown in Fig. 1, on the mounting base 34 first; (5) observing the images of the first and the second positioning marks using an alignment scope 31 shown in Fig. 1, where the images of the first positioning marks are obtained by light reflected from the first positioning marks and passed through a half mirror 25, a field lens 29, and reflectors 30, and the images of the second positioning marks are obtained by light reflected from the second positioning marks and passed through trapezoidal reflector 26, convex mirror 28, concave mirror 27, half mirror 25, field lens 29, and reflectors 30, the first and the second positioning marks being provided so that their images can be observed superimposed to each other by the alignment scope 31 ; (6) detecting a deviation appearing between the images of first and of the second marks, paying attention to whether wrong orthogonality and runout occurs between said images ; (7) aligning the position of carriage 32 by adjusting an air bearing controller, which is not shown in Fig. 1, until said deviation is minimized observing alignment scope 31 ; (8) developing the re-exposing substrate ; and (9) confirming whether the alignment has been correctly performed or not by inspecting any deviation appearing between the images of the first and second marks formed on the work mask by the development.

After the alignment step, the exposing step is carried out by : (1) removing the standard marker substrate from mounting base 34 ; (2) mounting re-exposing substrate 5 on mounting base 34 ; (3) exposing the standard photomask pattern of master mask 101 to re-exposing substrate 5 ; and (4) repeating the above steps (2) and (3) to the rest of the re-exposing substrates until all of the re-exposing substrates are exposed.

However, even though the intial alignment step has been correctly carried out, there is a possibility that the deviation between the images of the marks increases, because unavoidable mechanical vibrations and temperature changes occur in the mask aligner during the exposing steps which takes a relatively long time for exposing the photomask patterns onto a plurality of re-exposing substrates. Performing the alignment step for each re-exposing substrate would solve the above problem, but is actually impossible to do so because this would take too long a time. Then, if the work masks obtained are applied to the production of semiconductor devices without any inspection, the yield rate of the production of the semiconductor devices would be decreased. Therefore, usually, the work photomask patterns of the work masks are individually inspected by, for example, a pattern comparing inspecting method before applying the work mask to the production of the semiconductor devices.

Thus, in the prior art, a high transcribing accuracy cannot be kept in the production of the work masks, making it necessary to individually inspect the work photomask patterns of the work masks, which takes a lot of time.

These drawbacks can be eliminated by using the method and apparatus according to the invention of which different embodiments will now be described.

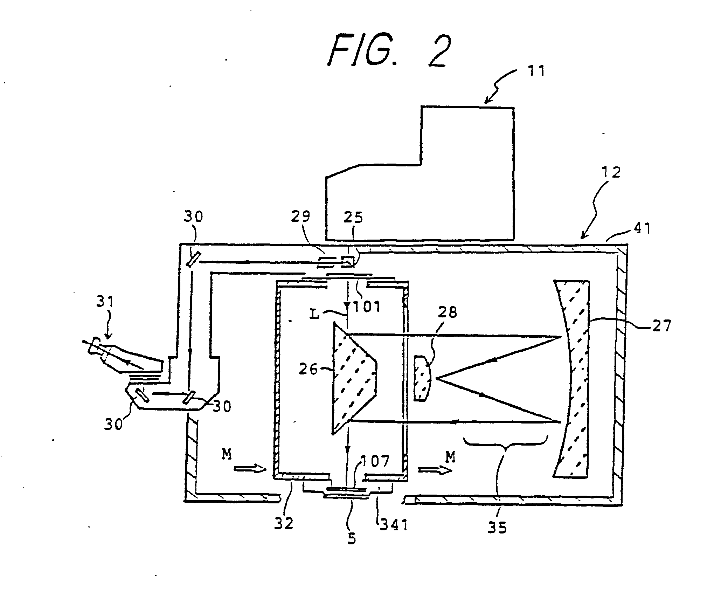

Fig. 2 is schematical cut view of a first mask aligner embodying the present invention when the focal length of the condensing mirror system used in the projecting optical unit of the mask aligner is long. In Figs. 1 and 2, the elements or parts having the same reference numerals have the same functions. In Fig. 2, reference numeral 341 is a mount base on which re-exposing substrate 5 is mounted, and a standard marker substrate 107 which has the second positioning marks is fixed to the carriage 32 at a location on the path of light beam L, in close proximity to the mounted re-exposing substrate 5. The light beam L which has passed through a master mask 101 arrives at re-exposing substrate 5 through trapezoidal mirror 26 and condensing mirror system 35 consisting of concave mirror 27 and convex mirror 28. Accordingly, the images of the standard photomask pattern and the first positioning marks, which are formed around the standard photomask pattern of master mask 101, are projected one re-exposing substrate 5 by the condensing mirror system 35, and, at the same time, the light beam L which has passed through the standard marker substrate 107 projects a shadow image of the second positioning marks of the standard marker substrate 107 onto re-exposing substrate 5, so that the images of the first and the second positioning marks are superimposed to each other on the surface of the re-exposing substrate 5.

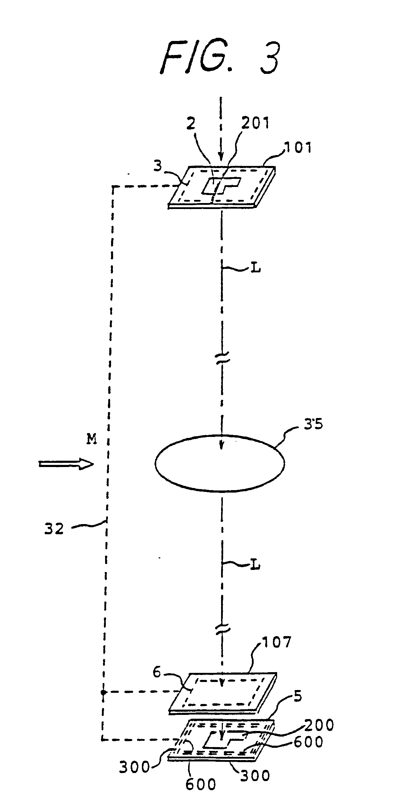

Fig. 3 optically illustrates how the image of standard photomask pattern 2 is projected onto re-exposing substrate 5 and how the images of the first positioning marks 3 and of the second positioning marks 6 are projected onto re-exposing substrate 5 superimposing to each other.

In Figs. 2 and 3, the same reference numerals designate the same elements. The standard photomask pattern 2 is formed at the center of master mask 101, and a plurality of the first positioning marks 3 are arranged around the standard photomask pattern 2. The light beam L and the condensing mirror system 35 are fixed with respect to the framework 41 of the projecting optical unit 12 in Fig. 2. The master mask 101, standard marker substrate 107, and re-exposing substrate 5 are fixed to the carriage 32 which is movable with respect to framework 41 in direction M. The light beam L forms a spotlight 201 having the shape of a slender circular arc on the surface of master mask 101 and arrives at re-exposing substrate 5 passing through the condensing mirror system 35 and standard marker substrate 107 having the second positioning marks 6 with the same arrangement pitch as that of the first positioning marks 3. Since the master mask 101 and re-exposing substrate 5 are placed at conjugate points of the condensing mirror system 35, an image 200 of standard photomask pattern 2 and the image 300 of the first positioning marks 3 are projected onto re-exposing substrate 5 when the carriage 32 is moved in direction M. Moreover, since the standard marker substrate 107 is placed close to re-exposing substrate 5 on the path of the light beam L, the shadow image 600 of the second positioning marks 6 is also projected onto re-exposing substrate 5 where images 300 and 600 are superimposed.

Generally, a shadow image cannot be obtained so sharp as a focussed image ; however, when the focal length of condensing mirror system 35 is long and the distance between re-exposing substrate 5 and standard marker substrate 107 is short, the blur of shadow image 6 can be neglected. The light reflected from the first positioning marks 3 and the light reflected from the second positioning marks 6 arrive at the alignment scope 31. The alignment and the inspection with respect to the mounted positions of master mask 101 and re-exposing substrate 5 can be made by observing by means of the alignment scope 31 as explained before in Fig. 1. However, in this first embodiment of the invention, since the standard marker substrate 107 is always fixed to carriage 32, the inspection of the correct alignment can be performed anytime during the exposing step, by observing the alignment scope 31 ; therefore, the production of the work masks can be performed in a short time keeping the transcribing accuracy high. An alignment of the carriage means is performed so as to minimize any deviation observed between images of the first and second positioning marks, the inspection being performed by means of the alignment scope by checking whether said deviation is within a predetermined limited amount. A re-inspection of the images of the marks is performed by inspecting the images developed on the work mask, as in the hereinbefore mentioned alignment step, to confirm that the images of the marks in the alignment scope 31 are still useful for aligning the optical system.

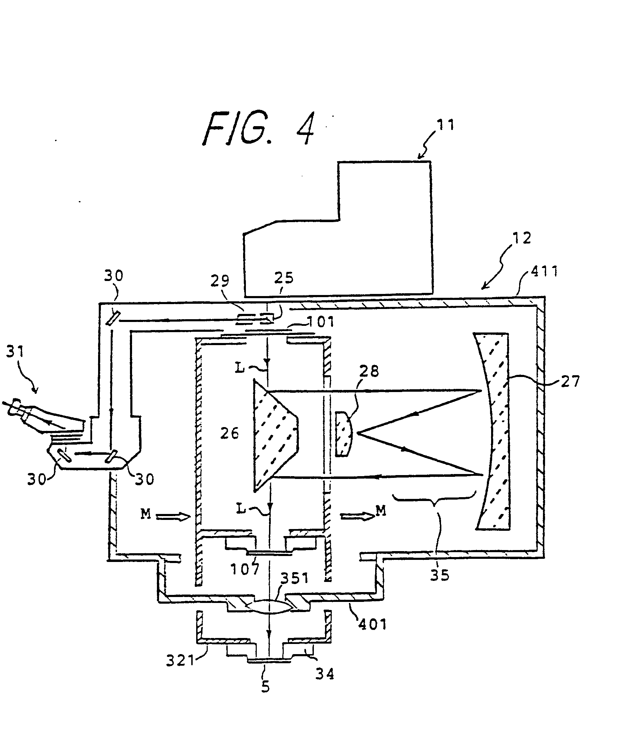

Fig. 4 is a schematic cut view of a second mask aligner embodying the present invention. In this embodiment, the focal length of the condensing mirror system is free from consideration. In the mask aligner of Fig. 4, the elements or parts having the same reference numerals or symbols as in Figs. 1 and 2 have the same functions as in the masks aligners of Figs. 1 and 2. A condensing optical system 351 is newly provided on an extended line of light beam L beyond the image point of the condensing mirror system 35, on which re-exposing substrate 5 is mounted in the first embodiment of the invention. Thus, the condensing mirror system 35 and the newly provided optical system 351 have a common optical axis and are optically connected at said image point. The image point will be hereinafter referred to as an optically relaying node where the standard marker substrate 107 is fixed. The re-exposing substrate 5 is mounted at the image point of condensing optical system 351 ; therefore, it can be said that the mounted positions of the master mask 101 and re-exposing substrate 5 are at the conjugate points of the total optical system consisting of condensing mirror system 35 and condensing optical system 351 optically connected at the optically relaying node. The condensing optical system 351 is fixed to the framework 411 of the mask aligner by a support arm 401 which is internally projected from framework 411.

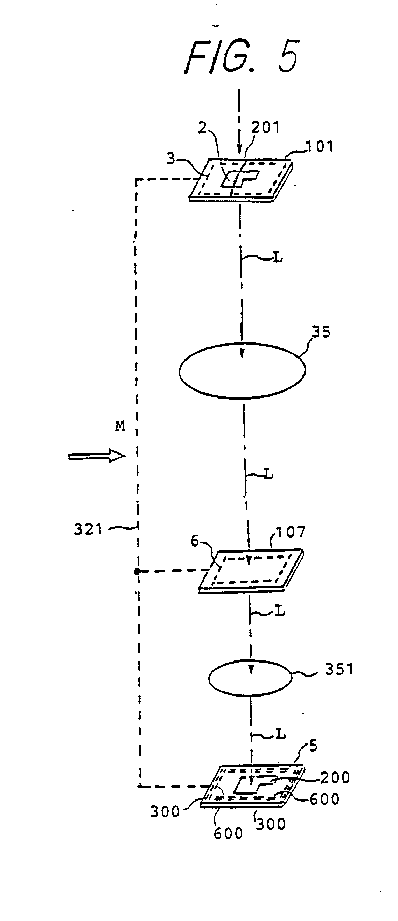

Fig. 5 optically illustrates how the image of the standard photomask pattern 2 of master mask 101 is projected onto re-exposing substrate 5 and how the images of the first positioning marks 3 of master mask 101 and the second positioning marks 6 of standard marker substrate 107 are projected onto re-exposing substrate 5 superimposed to each other. In Figs. 3, 4 and 5, the same reference numerals designate the same elements. Similarly to what has been discussed with respect to Fig. 3, when the carriage 321 moves in direction M carrying master mask 101, standard marker substrate 107, and re-exposing substrate 5, the images of standard photomask pattern 2 and the first positioning marks 3 are imaged on the surface of standard marker substrate 107 once by the condensing mirror system 35 and are projected on the surface of the re-exposing substrate 5 producing the projected images 200 and 300. At the same time, by the above scanning, the image of the second positioning marks 6 is projected on the surface of re-exposing substrate 5 producing the projected image 600 so as to be superimposed with the projected image 300. The alignment step and projecting steps are carried out similarly to what has been discussed in connection with Figs. 2 and 3, observing the images of the first positioning marks 3 and of the second positioning marks 6. In the mask aligner of Figs. 4, 5, the standard marker substrate 107 is placed at the image point of the condensing mirror system 35, so that there is no blur around image 600. In this second embodiment of the invention, as in the first embodiment, the alignment inspection can be performed by observing alignment scope 31 during the exposing step. The exposure can be made in a short time keeping the transcribing accuracy high, and a re-inspection of the images of the marks is made by inspecting the positioning marks developed on the work mask to confirm that the images of the marks in the alignment scope are still useful for aligning the optical system.

As discussed above, when the first and the second embodiments are applied to the production of the work masks, the inspection as to the transcribing accuracy of photomask pattern can be made easily by observing through the alignment scope 31 in the projecting step, and the operations of mounting and demounting the standard marker substrate 107 are no longer necessary. Since the inspection can be made for each re-exposing substrate individually, the problem of irregular exposure due to mechanical vibrations or temperature changes of the mask aligner during the exposing step can be eliminated.

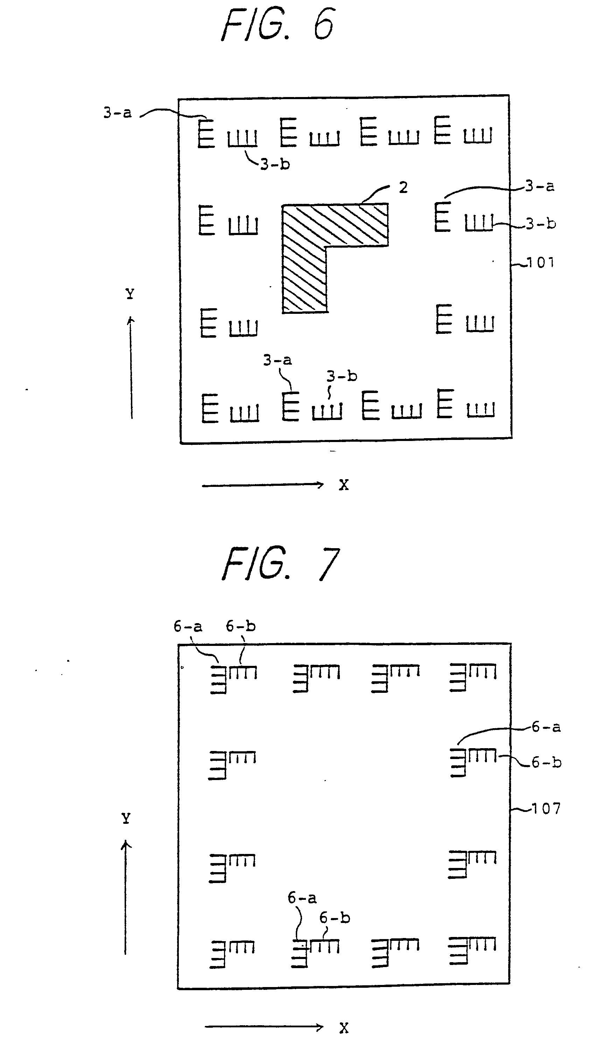

The first positioning marks 3 of the master mask 101 are provided as shown in Fig. 6, and the second positioning marks 6 of standard marker substrate 107 are provided as shown in Fig. 7. In Fig. 6, the first positioning marks 3 are arranged around the standard photomask pattern 2 which is placed at the center part of master mask 101, and the first positioning marks 3 are classified into two groups : group 3-a and group 3-b. Each mark in each group has a scale, the marks of group 3-a having a scale arranged in X direction and the marks of group 3-b having a scale arranged in Y direction as shown in Fig. 6.

The second position marks 6 are in the same number as the first positioning marks 3. The second positioning marks 5 are also classified into two groups : group 6-a and group 6-b. The marks of groups 6-a and 6-b are arranged corresponding to the marks of groups 3-a and 3-b, recpectively, as shown in Fig. 7, and each mark in each group has a scale which functions as a vernier scale with respect to the scale of a corresponding first positioning mark 3.

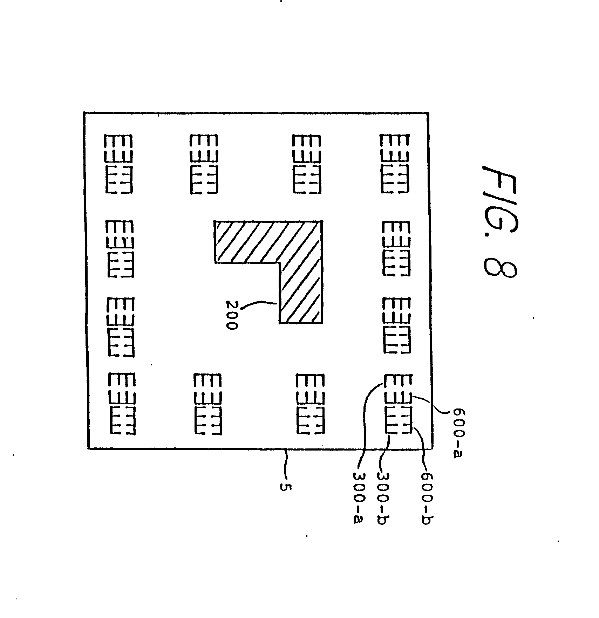

Fig. 8 shows the images projected onto the re-exposing substrate 5. The image 200 is the projected image of standard photomask pattern 2 of master mask 101, images 300-a and 300-b are the projected images of the first positioning marks 3-a and 3-b of master mask 101, respectively, and images 600-a and 600-b are the projected images of the second positioning marks 6-a and 6-b of standard marker substrate 107, respectively. The same images as the images of groups 300-a, 300-b, 600-a, and 600-b can be observed by means of the alignment scope 31. The alignment and the inspection can be made by checking any deviation between corresponding facing scales.

In the above detailed description, the re-exposing substrates are designed to become work masks ; however, the present invention can also be applied to re-exposing substrates designed to form semiconductor wafers.

## Claims

1. A mirror projecting mask aligner comprising a light source unit (11) and a projecting optical unit (12) in which a carriage means (32) is installed for carrying a master mask (101), a re-exposing substrates (5) and a standard marker substrate (107), characterised in that the standard marker substrate (107 ; Figure 3) is permanently positioned in close proximity to said re-exposing substrate (5).

2. A mirror projecting mask aligner comprising a light source unit (11) and a projecting optical unit (12) with an optical imaging mirror system (35) and a carriage means (32) for carrying a master mask (101), a re-exposing substrate (5) and a standard marker substrate (107), characterised in that the standard marker substrate (107 ; Figures 4, 5) is permanently positioned in the focal plane of said optical imaging mirror system (35), and that a further optical imaging means (351) is provided for imaging the image of the master mask (101) and position marks (6, Figure 7) of said standard marker substrate (107) onto said re-exposing substrate (5).

## Patentansprüche

1. Spiegelprojektionsmaskenausrichter mit einer Lichtquelleneinheit (11) und einer optischen Projektionseinheit (12), in welcher eine Schlitteneinrichtung (32) installiert ist, um eine Vorlagenmaske (101), ein Wiederbelichtungssubstrat (5) und ein Standardmarkierungssubstrat (107) zu tragen, dadurch gekennzeichnet, daß das Standardmarkierungssubstrat (107 ; Figur 3) permanent in dichter Nähe bei dem genannten Wiederbelichtungssubstrat (5) positioniert ist.

2. Spiegelprojektionsmaskenausrichter mit einer Lichtquelleneinheit (11) und einer optischen Projektionseinheit (12), mit einem optischen Spiegelabbildungssystem (35) und einer Schlitteneinrichtung (32), um eine Vorlagenmaske (101), ein Wiederbelichtungssubstrat (5) und ein Standardmarkierungssubstrat (107) zu tragen, dadurch gekennzeichnet, daß das Standardmarkierungssubstrat (107 ; Figuren 4, 5) permanent in der Brennebene des genannten optischen Spiegelabbildungssystems (35) positioniert ist, und daß ein weiteres optisches Abbildungssystem (351) zur Abbildung des Bildes der Vorlagenmaske (101) und Positionsmarken (6, Figur 7) des genannten Standardmarkierungssubstrats (107) auf das genannte Wiederbelichtungssubstrat vorgesehen ist.

## Revendications

1. Dispositif d'alignement de masque à projection par miroirs, comprenant une unité de source lumineuse (11) et une unité optique de projection (12) dans laquelle un chariot (32) est installé de manière à transporter un masque mère (101), un substrat de réexposition (5) et un substrat de repérage normalisé (107), caractérisé en ce que le substrat de repérage normalisé (107 ; figure 3) est placé de manière permanente à proximité étroite dudit substrat de réexposition (5).

2. Dispositif d'alignement de masque à projection par miroirs, comprenant une unité de source lumineuse (11) et une unité optique de projection (12) associée à un système de miroirs de formation d'image optique (35) et à un chariot (32) servant à transporter un masque mère (101), un substrat de réexposition (5) et un substrat de repérage normalisé (107), caractérisé en ce que le substrat de repérage normalisé (107 ; figures 4 et 5) est placé de manière permanente dans le plan focal dudit système de miroirs de formation d'image (35) et en ce qu'un moyen supplémentaire de formation d'image optique (351) est destiné à former une image de l'image du masque mère (101) et de repères de position (6, figure 7) dudit substrat de repérage normalisé (107) sur ledit substrat de réexposition (5).

# FIG. 1

Prior Art

# FIG. 2

# FIG. 3

FIG. 4

FIG. 5

## FIG. 6

## FIG. 7

# FIG. 8

600-a
600-b
300-b
300-a
5
200